Europäisches Patentamt

European Patent Office

Office européen des brevets

(11) Publication number: **0 187 512**
**B1**

## (12) EUROPEAN PATENT SPECIFICATION

(45) Date of publication of patent specification: **28.03.90**

(51) Int. Cl.⁵: **B 65 D 3/22, B 32 B 27/08**

(21) Application number: **85309329.2**

(22) Date of filing: **20.12.85**

(54) **Transparent plastics material can.**

(30) Priority: **30.12.84 JP 280702/84**

(43) Date of publication of application:
**16.07.86 Bulletin 86/29**

(45) Publication of the grant of the patent:
**28.03.90 Bulletin 90/13**

(84) Designated Contracting States:
**DE FR GB**

(56) References cited:
**DE-A-3 300 411**

(73) Proprietor: **AJINOMOTO CO., INC.**
**5-8, Kyobashi 1-chome, Chuo-ku**
**Tokyo 104 (JP)**

(72) Inventor: **Sasaki, Hitoshi**
**No. 2-89, Shinmei-cho Saiwai-ku**
**Kawasaki-shi Kanagawa-ken (JP)**
Inventor: **Igota, Shoji**
**No. 1-18-11, Fujisaki Kawasaki-ku**
**Kawasaki-shi Kanagawa-ken (JP)**

(74) Representative: **Bond, Bentley George et al**
**Haseltine Lake & Co. 28 Southampton Buildings**
**Chancery Lane**
**London WC2A 1AT (GB)**

Courier Press, Leamington Spa, England.

**Description**

The present invention relates to a plastics material can which is used as a container for foods and drinks.

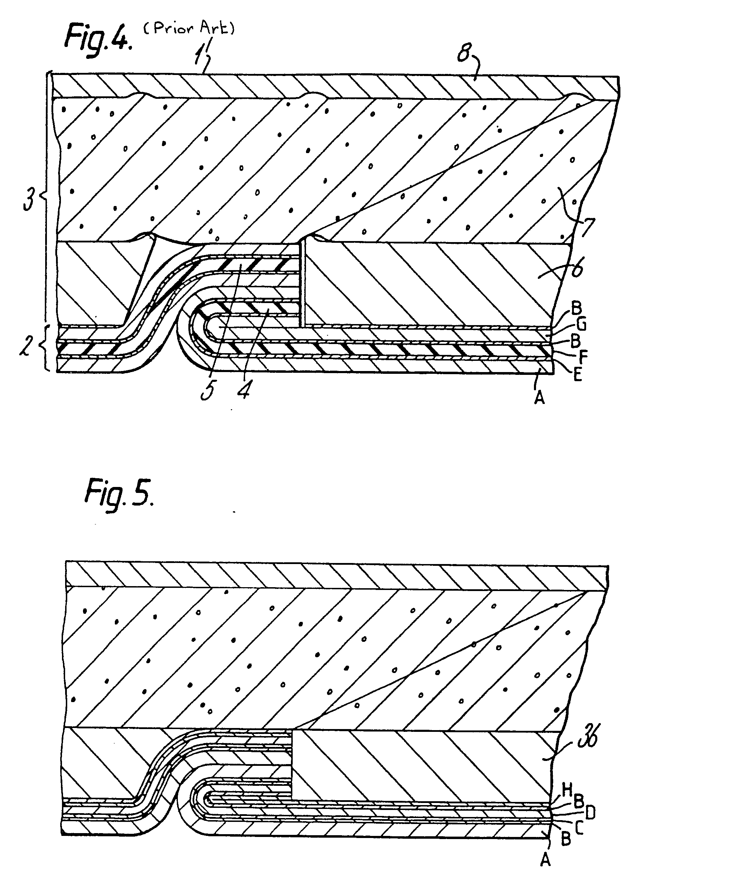

Metal cans have conventionally been used as containers for foods and drinks. Recently plastics material cans, plastics material bottles and plastics material cups have been developed because of their ease of production and disposal and their low cost, and are now available in various forms, as produced by injection moulding, blow moulding and vacuum forming. They are used for a large variety of foods and drinks including edible oils, seasonings, and desserts. The present inventors made several inventions in this field, as disclosed in Japanese Laid-Open Patent Applications Nos. 11146/1983, 153629/1983 and 209561/1983; Japanese Laid-open Utility Model Applications Nos. 35315/1984 and 35333/1984; and EP—A—0113160 (A-568), EP—A—0163492 (A-645) and European Patent Application No. 85308282.4 (EP—A—0183440) (A-661). Usually these plastics material cans have a can body made of laminated material that meets different requirements according to the intended application. In Japan, plastics material cans for foods and drinks are required to conform to the Food Sanitation Law and to have ·properties such as water resistance, oil resistance, retortability, a self-supporting abiltiy, and gas barrier properties. The can body of a known plastic material can (see, for example, Japanese Laid-open Patent Application No. 214627/1984) is illustrated by a partly enlarged sectional view in Fig. 4 of the accompanying drawings. In this particular embodiment, the cylinder 1' forming the can body is made up of a contents protecting layer which consists of a laminated film 2 and a supporting layer 3. Thus, the laminated film consists of the following five layers, laminated one upon another, as shown in Fig. 4;

A: undrawn polypropylene layer, 70 microns in thickness (innermost layer);
E: Adhesive layer (carboxylic acid-grafted polypropylene), 7 microns in thickness;
F: Aluminium foil, 9 microns in thickness;
B: Urethane adhesive layer (4.5 g/m²);
G: Undrawn polypropylene layer, 30 microns in thickness.

One edge 4 of laminated film 2 is folded back and the facing surfaces are bonded together. The other edge 5 is overlapped and bonded to the folded edge 4. The supporting layer 3 consists of the following four layers laminated one upon another;

B: Urethane adhesive layer (4.5 g/m²) (inner layer);
6: Wrapping sheet of undrawn polypropylene, 200 microns in thickness (to fill the hollow space between the seams formed by folding and overlapping the edges of the laminated film 2);
7: Intermediate plastics material layer, about 600 microns in thickness, made of a 1:1 mixture of polypropylene and calcium carbonate;
8: Top coating layer, 10 to 20 microns in thickness, made of polypropylene block copolymer.

Transparent foods and drinks containers now in general use are mostly of a single-layered structure made of a clear plastics material such as polyester, polypropylene or polystyrene. Such containers are poor in gas barrier properties and do not preserve foods and drinks for a long period of time. In an attempt to improve the gas barrier properties, there has been proposed a container having a multi-layered structure, with a polyvinyl alcohol layer being interposed between two polypropylene layers. This container has the drawback that the polyvinyl alcohol loses its gas barrier properties upon moisture absorption. Thus, it is not suitable for long-term storage of watery foods and sterilized foods.

In the case of the known plastics material cans as devised by the present inventors, the can body contains a layer of aluminium foil, which is necessary for gas barrier properties, and a layer of a polypropylene - calcium carbonate mixture. Therefore, the can body is opaque and keeps the contents from sight. Opaque cans are undesirable containers for those products which must appeal to the eye of the consumer. In addition, these known plastics materials cans cannot be heated in a microwave oven because the aluminium foil layer reflects microwaves.

In EP—A—0113160 referred to above, there is disclosed a plastics material can comprising a tubular body made from a laminated film consisting of an inner contents-protecting laminated layer and an outer supporting layer laminated thereto, said inner laminated layer comprising at least three layers, the innermost layer being a polyolefin, said tubular body being formed by joining edges of said laminated film, one edge of said laminated film being folded back upon itself and another edge of said laminated film being overlapped with said folded edge and bonded thereto.

According to the present invention, there is provided plastics material can comprising a tubular body made from a laminated film consisting of an inner contents-protecting laminated layer and an outer suppporting layer laminated thereto, said inner laminated layer comprising at least three layers, the innermost layer being a polyolefin, said tubular body being formed by joining edges of said laminated film, one edge of said laminated film being folded back upon itself and another edge of said laminated film being overlapped with said folded edge and bonded thereto, characterised in that the laminated film from which the tubular body is made is transparent both to visible light and to microwave radiation and the inner contents-protecting laminated layer contains an internal layer of plastics material with a layer of silicon oxide deposited thereon by vacuum evaporation or sputtering, the silicon oxide layer being placed on the inside.

The present invention provides a plastics material can which is free of the above-mentioned problems and drawbacks. A feature of the plastics material can is the fact that its body is made of a transparent laminated film containing a layer of silicon oxide formed by deposition or sputtering.

The layer of silicon oxide usually has a thickness of from 0.02 to 0.2 microns.

The tubular body is preferably formed by spirally winding said laminated film.

Preferably, the outer supporting layer comprises an additional plastics material layer over the outer surface of inner layer, except for the projecting seam formed by the bonding of said folded edge to said other edge, the thickness of said additional layer being approximately equal to the height of said projecting seam; and, if desired, further comprises at least one plastics material layer over the outer surface of said additional layer and over the outer surface of said projecting seam.

The transparent can body makes the contents of the can visible. The can is capable of being heated in a microwave oven.

The silicon oxide may be either silicon monoxide or silicon dioxide, or a combination thereof.

The plastics material layer onto which the silicon oxide is deposited is, for example, biaxially orientated polypropylene film, polyester film, biaxially orientated nylon film, polycarbonate film or polystyrene film.

The deposition or sputtering of silicon oxide may be accomplished by a known method. The silicon oxide layer formed by deposition or sputtering should be thick enough for the gas barrier properties required. The thickness is usually 0.02 microns and above, preferably 0.05 to 0.2 microns.

Usually, one silicon oxide layer is enough, but two or more layers may be formed, if desired. The silicon oxide layer is an internal layer rather than an outermost layer in the laminated film.

The other layers in the laminated film may be selected according to the intended use of the can. Thus, the laminated film has an innermost polyolefin layer it is intended for can bodies of foods and drinks cans. The outer layer of polypropylene-calcium carbonate mixture, which is present in the known plastics material can, may be replaced by a transparent polypropylene layer in the plastics material can of this invention.

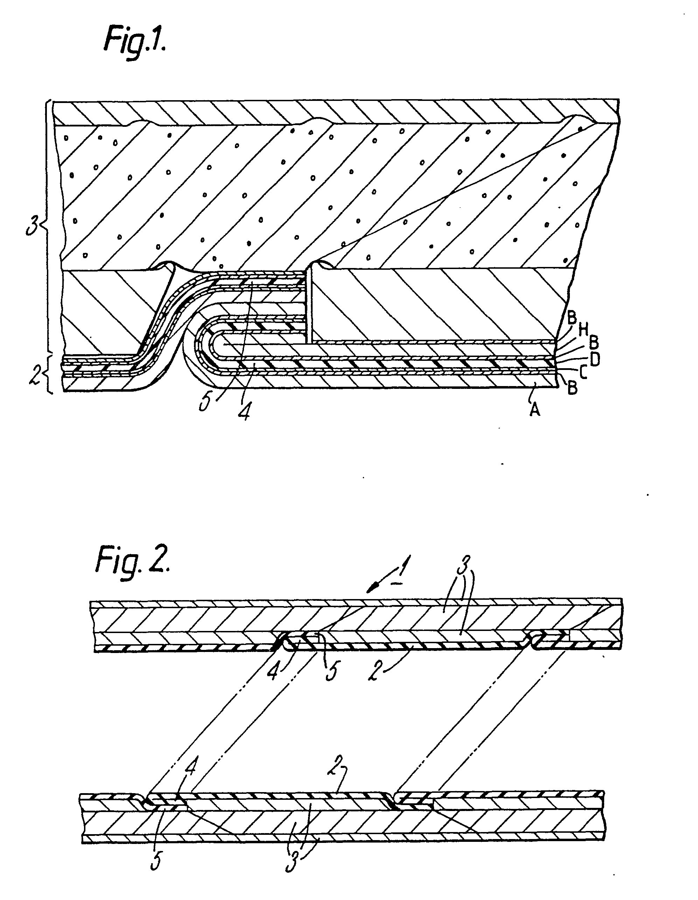

In forming a tubular body by joining the edges of the laminated film, one edge of the laminated film 2 is folded back and the other edge 5 is overlapped onto the folded edge, and is bonded thereto, as shown in Fig. 1 of the drawings, so that the faces of the edges of the laminated film do not come into contact with the contents of the can. The joint thus formed may be spiral or straight in the longitudinal direction.

The silicon oxide layer formed by vacuum evaporation or sputtering maintains good gas barrier properties even in the case of watery foods and sterilized foods, and hence permits food to be preserved for a long period of time. In addition, it is transparent to both visible light and microwaves.

The invention will now be illustrated by the following Examples, in conjunction with Figs. 1 to 3 and 5 to 7 of the drawings.

Example 1

A three-layered laminated film was produced from 25 microns thick biaxially orientated polypropylene film having thereon a silicon oxide vacuum evaporated layer of a thickness of 0.1 microns (1000 Angstroms), 70 microns thick undrawn polypropylene film, and 30 microns thick undrawn polypropylene film. The layers were bonded one upon another in the order given, using a urethane adhesive in an amount of 4.5 g/m$^2$, the silicon oxide layer being placed on the inside.

This laminated film was made into a can body 1 using an apparatus as schematically shown in Fig. 3. Thus, the laminated film 2, fed from a stock roll 10, was passed through an edge folding unit 11 that folds back one edge 4 of the laminated film 2. The film 2 then passes under a mandrel 12 and reaches a pressing roll 13. In addition, a wrapping sheet 6 fed from a stock roll 14, was coated on one side with an adhesive by an adhesive applicator 15, the adhesive being dried by a hot-air dryer 16. The wrapping sheet 6 was bonded to the laminated film 2 by the pressing roll 13. The laminated sheet 17 thus formed was wound around the mandrel 12. The overlapped edges 4 and 5 of the laminated film 2 were bonded together by the use of an air heater 18. The laminated sheet 17 wound around the mandrel 12 was then covered with a molten plastics material extruded from a T-die 19. The molten plastics material was smoothed by a smoothening belt 20, whereby an intermediate plastics material layer 7 (see Fig. 1) was formed. The intermediate plastics material layer 7 was further covered with a molten plastics material smoothed by a doctor knife 21, whereby a top coating layer 8 (see Fig. 1) was formed. The tubular body leaving the mandrel was cut to length by a cutter 22.

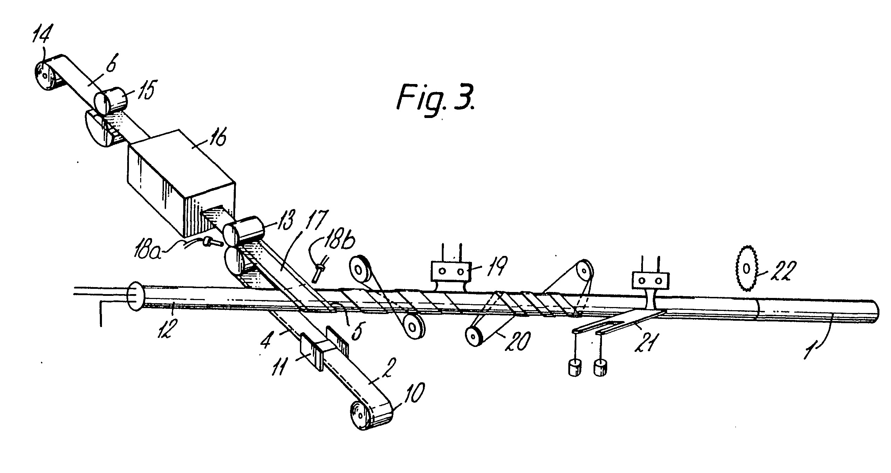

The can body produced as above has a structure as shown in Fig. 1 (partly enlarged sectional view) and Fig. 2 (longitudinal sectional view). The laminated film 2 consists of 70 microns thick undrawn polypropylene layer (A), a urethane adhesive layer, 4,5 g/m$^2$, (B), a 0.1 microns (1000 Angstroms) thick silicon monoxide deposited film layer (C), a 25 microns thick biaxially orientated polypropylene layer (D), a urethane adhesive layer, 4.5 g/m$^2$, (B), and a 30 microns thick undrawn polypropylene layer (H). The laminated film 2 is spirally wound into a tubular body such that one edge 4 of the laminated film 2 is folded back and bonded, and the other edge 5 is overlapped onto the folded edge 4, and is bonded thereto. The supporting layer 3, outside the laminated film 2, has a structure similar to that of the known can body, as shown in Fig. 4, but the layer of polypropylene-calcium carbonate mixture 7 is replaced by a layer of 100% polypropylene.

The can body produced as above was provided with an injection moulded plastics material lid and an

3

injection moulded plastics material base to form a can. The can was transparent and the contents were visible. The can had good gas barrier properties and was capable of being heated in a microwave oven.

Example 2

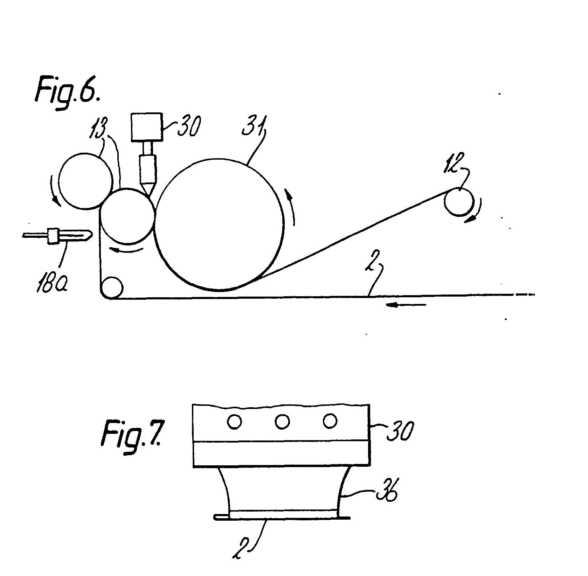

A can body was produced in the same manner as in Example 1, except that the biaxially oriented polypropylene film D was replaced by 12 microns thick polyethylene terephthalate film, and except that a melt extruded polypropylene layer was used in the place of the sheet 6. The apparatus for the production of this can body is basically the same as the apparatus which is schematically illustrated in Fig. 3, except that the points pertaining to the sheet 6 (i.e. roll 14, applicator 15 and hot air drier 16 as shown in Fig. 3) are no longer used. In their place, a device as illustrated in Fig. 6 is used. In the apparatus of Fig. 6, a T-die 30 is disposed in part of a press roll 13, and a cooling roll 31 is disposed in opposition to the press roll 13 across an intervening space three times the thickness of the laminated film 2.

The laminated film 2, having one lateral edge thereof folded back by the edge-folding device, is brought in from the right-hand side of Fig. 6. The folded part is heated by a cartridge air heater 18a and then pressed down into fast union by the press roll 13. Via the T-die 30, molten plastics material for forming the layer 36 is extruded with a prescribed width and applied onto the laminated film 2 as illustrated in Fig. 7. The applied molten plastics material is cooled by the cooling roll 3 and rolled to an even thickness, and the laminated film and applied plastics material are forwarded to the mandrel 12. Thereafter, the laminated film and the applied plastics material layer are treated as illustrated in Fig. 3 to produce a can body. The can body has a structure as shown in Fig. 5 (enlarged sectional view). The can body was provided with metal lid and a metal base to form a can. As in Example 1, the can was transparent and the contents were visible. The can had good gas barrier properties and was capable of being heated in a microwave oven.

Example 3

The plastics material cans prepared in Examples 1 and 2 were examined for their performance by field tests. For comparison, containers of approximately the same size and constructed of a single layer of polypropylene (PP cans) were also examined in the same manner.

Various cooked foods, as shown in the following Table, were placed in the cans, and the cans were subjected to sterilization with hot water at 125°C. The taste of the foods was evaluated by organoleptic tests immediately after sterilization and 12 months after preservation in a room at 20 to 30°C (before the test, the foods were heated using a microwave oven). The organoleptic tests were conducted by 10 panelists. The test results were indicated by points for each of appearance, flavour, taste, texture, and odour. The criteria for points were as follows:

5.0...Excellent

4.0...Good

3.0...Fair (acceptable as a commercial product)

2.0 to 1.0...Poor (no commercial value)

0...Uneatable.

TABLE

| Name of food | Raw materials | Steril-ization | Just after sterilization | | | | After preservation for 12 months | | | | | |
|---|---|---|---|---|---|---|---|---|---|---|---|---|
| | | | PP cans | | The invention | | Polypropylene cans | | | Cans of the invention | | |
| | | | Point | Colour | Point | Colour | Point | Colour | Other | Point | Colour | Other |
| 1. Short-neck clam boiled in plain water (as food material) | Short-neck clam, salt | 50 min | 5.0 | Good | 5.0 | Good | 1.0 | Browning | Flavour and taste deteriorated; no commercial value | 4.0 | Slight browning | Taste slightly lost |
| 7. Bamboo shoot boiled in plain water (as food material) | Bamboo shoot | 65 min | 5.0 | Good | 5.0 | Good | 2.0 | Browning | Unusual taste; poor texture | 4.3 | Slight browning | Texture slightly poor |
| 3. Common mushroom (as food material) | Mushroom, salt, L-ascorbic acid, pH adjustor, seasonings | 50 min | 5.0 | Good | 5.0 | Good | 2.0 | Browning | Unusual taste; poor texture; no commercial value | 4.5 | Slight browning | Taste slightly lost |
| 4. Mixed seasonings for Habo Wasu (Chinese food) | Soy sauce, Sake, edible oil, tomato ketchup, ginger root, seasonings, scallops, beef extract, salt | 40 min | 5.0 | Good | 5.0 | Good | 1.0 | Browning | Taste lost, salty, no commercial value | 4.5 | Slight browning | Taste slightly lost |

TABLE (contd.)

| Name of food | Raw materials | Sterilization | Just after sterilization | | | | After preservation for 12 months | | | | | |
| | | | PP cans | | The invention | | Polypropylene cans | | | Cans of the invention | | |
| | | | Point | Colour | Point | Colour | Point | Colour | Other | Point | Colour | Other |
|---|---|---|---|---|---|---|---|---|---|---|---|---|
| 5. Mixed seasonings for Borsch | Tomato, red beats, salt, seasonings, spice, meat extract, vegetable extract | 45 min | 5.0 | Good | 5.0 | Good | 1.0 | Tomato browned | Taste lost, unusual taste, no commercial value | 4.3 | Tomato slightly browned | Taste slightly lost |
| 6. Mixed seasonings for Pork curry | Edible oil, milk, wheat flour, sugar, salt, protein hydrolyzate, meat extract, Kaorina | 50 min | 5.0 | Good | 5.0 | Good | 2.0 | Browning | Curry taste lost; no commercial value | 4.5 | Slight browning | Taste slightly lost |
| 7. Soup (corn cream) as processed food | Sweet corn, milk wheat flour, sugar, salt, edible oil, seasonings, protein hydrolyzate, meat extract, spice | 60 min | 5.0 | Good | 5.0 | Good | 1.0 | Browning | Taste lost; unusual flavor; no commercial value | 4.5 | Slight browning | Corn taste slightly lost |
| 8. "Sankaini" as processed food | Bamboo shoot, tuna flake, elephant food, seasonings | 70 min | 5.0 | Good | 5.0 | Good | 2.0 | Browning | Taste lost; unusual flavor; no commercial value | 4.5 | Slight browning | Taste slightly lost |

# EP 0 187 512 B1

It is noted from the Table that there is no significant difference, in respect of the contents, between the plastics materials cans of this invention and the polypropylene cans when tested immediately after sterilization. However, after storage at room temperature for 12 months, the foods in the polypropylene cans deteriorated to such an extent that they are of no commercial value, whereas the plastics material cans of this invention preserved the foods almost intact. No difference was observed between the plastics material cans of Example 1 and those of Example 2. The plastics material cans of this invention permit heating of the contents with a microwave oven after the cans are opened.

This invention thus provides plastics material cans that can be easily produced at a low cost and are easily disposed of after use. The plastics material cans of this invention maintain their gas barrier properties, so that they preserve watery foods and sterilized foods for a long period of time. The plastics material cans of this invention are transparent and make the contents appeal to the eye of the consumer. They are also transparent to microwaves, thereby permitting the contents to be heated by a microwave oven while in the can.

## Claims

1. A plastics material can comprising a tubular body (1) made from a laminated film consisting of an inner contents-protecting laminated layer (2) and an outer supporting layer (3) laminated thereto, said inner laminated layer (2) comprising at least three layers, the innermost layer being a polyolefin (A), said tubular body (1) being formed by joining edges (4, 5) of said laminated film, one edge (4) of said laminated film being folded back upon itself and another edge (5) of said laminated film being overlapped with said folded edge (4) and bonded thereto, characterised in that the laminated film from which the tubular body (1) is made is transparent both to visible light and to microwave radiation and the inner contents-protecting laminated layer (2) contains an internal layer (D) of plastics material with a layer of silicon oxide (C) deposited thereon by vacuum evaporation or sputtering, the silicon oxide layer (C) being placed on the inside.

2. A can as claimed in Claim 1, wherein said silicon oxide layer (C) has a thickness of at least 0.02 microns.

3. A can as claimed in Claim 2, wherein said silicon oxide layer (C) is of a thickness ranging from 0.05 to 0.2 microns.

4. A can as claimed in any of Claims 1 to 3, wherein said tubular body (1) is closed by fusion bonding lids thereto.

5. A can as claimed in Claim 4, wherein said lids are metal can lids or injection molded plastic can lids.

6. A can as as claimed in any of Claims 1 to 5, wherein said silicon oxide layer (C) is silicon monoxide or silicon dioxide.

### Patentansprüche

1. Büchse aus Kunststoffmaterial, enthaltend einen rohrförmigen Körper (1), der aus einer Schichtfolie gefertigt ist, die aus einer den Inhalt schützenden, mehrlagigen Innenschicht (2) und aus einer an diese laminierten äußeren Stützschicht (3) aufgebaut ist, wobei die besagte mehrlagige Innenschicht (2) mindestens drei Schichten, deren innerste ein Polyolefin (A) ist, umfaßt, und der besagte rohrförmige Körper (1) durch Aneinanderfügen der Ränder (4, 5) der Schichtfolie geformt wird, wobei ein Rand (4) der besagten Schichtfolie auf sich selbst zurückgefaltet wird, und der andere Rand (5) der besagten Schichtfolie mit dem besagten gefalteten Rand überlappt und mit diesem verbunden wird, dadurch gekennzeichnet, daß die Schichtfolie, aus der der rohrförmige Körper (1) gefertigt ist, sowohl für sichtbares Licht als auch für Mikrowellen durchlässig ist, und daß die den Inhalt schützende, mehrlagige Innenschicht (2) eine innere Schicht (D) aus Kunststoffmaterial enthält, die auf eine Siliciumoxidschicht (C) durch Aufdampfen im Vakuum oder Sputtern aufgetragen ist, wobei sich die Siliciumoxidschicht (C) auf der Innenseite befindet.

2. Eine Büchse nach Anspruch 1, deren Siliciumoxidschicht (C) eine Dicke von mindestens 0,02 µm hat.

3. Eine Büchse nach Anspruch 2, deren Siliciumoxidschicht (C) eine Dicke im Bereich von 0,05 bis 0,2 µm aufweist.

4. Eine Büchse nach einem der Ansprüche 1 bis 3, worin der rohrförmige Körper (1) verschlossen ist, indem Deckel durch Schmelzkleben an ihm befestigt wurden.

5. Eine Büchse nach Anspruch 4, deren Deckel Büchsendeckel aus Metall oder spritzgegossene Kunststoffdeckel sind.

6. Eine Büchse nach einem der Ansprüche 1 bis 5, deren Siliciumoxidschicht (C) Siliciummonoxid oder Siliciumdioxid ist.

### Revendications

1. Boîte en matière plastique comprenant un corps tubulaire (1) en un film stratifié consistant en une couche stratifiée interne (2) protégeant le contenu et en une couche externe (3) de support stratifiée sur la première, ladite couche stratifiée interne (2) comprenant au moins trois couches, la couche la plus interne étant une polyoléfine (A), ledit corps tubulaire (1) étant formé en joignant les bords (4, 5) dudit film stratifié,

7

un bord (4) dudit film stratifié étant replié sur lui-même et un autre bord (5) dudit film stratifié étant en chevauchement avec ledit bord replié (4) et étant lié à celui-ci, caractérisée en ce que le film stratifié à partir duquel est constitué le corps tubulaire (1) est transparent à la fois à la lumière visible et aux rayonnements micro-ondes et en ce que le couche stratifiée interne (2) protégeant le contenu contient une couche interne (D) en matière plastique sur laquelle est déposée une couche d'oxyde de silicium (C) par évaporation ou pulvérisation sous vide, la couche d'oxyde de silicium (C) étant disposée à l'intérieur.

2. Boîte selon la revendication 1, dans laquelle ladite couche d'oxyde de silicium (C) a une épaisseur d'au moins 0,20 μm.

3. Boîte selon la revendication 2, dans laquelle ladite couche d'oxyde de silicium (C) a une épaisseur comprise entre 0,05 et 0,2 μm.

4. Boîte selon l'une des revendications 1 à 3, dans laquelle ledit corps tubulaire (1) est fermé en y fixant des couvercles par fusion.

5. Boîte selon la revendication 4, dans laquelle lesdits couvercles sont des couvercles de boîtes métalliques ou des couvercles de boîtes en matière plastique moulés par injection.

6. Boîte selon l'une des revendications 1 à 5, dans laquelle ladite couche d'oxyde de silicium (C) est en monoxyde de silicium ou en dioxyde de silicium.

*Fig.1.*

*Fig. 2.*

Fig. 3

**Fig.4.** (Prior Art)

**Fig.5.**

Fig.6.

13    30    31    12

180    2

Fig.7.    30

36

2

4